# EUROPEAN PATENT APPLICATION

(11) **EP 4 195 289 A1**
(43) Date of publication of application: **14.06.2023**
(21) Application number: 22204877.9
(22) Date of filing: 01.11.2022
(51) Int. Cl.: H01L 29/45, H01L 29/417, H01L 29/78

(54) **METAL CARBON BARRIER REGION FOR NMOS DEVICE CONTACTS**

(30) Priority: 09.12.2021 US 202117546461
(71) Applicant: INTEL Corporation, Santa Clara, CA 95054 (US)
(72) Inventor: SEN GUPTA, Arnab, Hillsboro, 97124 (US); DEWEY, Gilbert, Beaverton, 97006 (US); CHOUKSEY, Siddharth, Portland, 97229 (US); HARATIPOUR, Nazila, Portland, 97209 (US); KAVALIEROS, Jack, Portland, 97229 (US); METZ, Mathew, Portland, 97229 (US); CLENDENNING, Scott, Portland, 97225 (US); RETASKET, Jason, Beaverton, 97007 (US); JOHNSON, Edward, Saint Helens, 97051 (US)
(74) Representative: Goddar, Heinz J.

(57) **Abstract**

Described herein are integrated circuit devices with source and drain (S/D) contacts with barrier regions. The S/D contacts conduct current to and from semiconductor devices, e.g., to the source and drain regions of a transistor. The barrier regions are formed between the S/D region and an inner conductive structure and reduce the Schottky barrier height between the S/D region and the contact. The barrier regions may include one or more carbon layers and one or more metal layers. A metal layer may include niobium, tantalum, aluminum, or titanium.

## Description

### Technical Field

This disclosure relates generally to the field of integrated circuit (IC) structures and devices, and more specifically, to contact materials incorporated in such IC structures and devices.

### Background

In IC devices, electrically conductive contacts provide electrically conductive paths to transistors and other circuit elements. For example, a transistor typically has a source contact and a drain contact, which are coupled to a respective source and drain region in the transistor. The source and drain contacts are typically more conductive than the source and drain regions, e.g., the source and drain contacts may be a metal or metal alloy, while the source and drain regions are doped semiconductors. The source and drain contacts are further coupled to interconnect that delivers signal from or to another portion of the IC device.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional view showing an example arrangement of a one transistor one capacitor (1T-1C) memory cell with source and drain contacts, according to some embodiments of the present disclosure.
FIG. 2 is perspective view of a cross-section of a contact over a source or drain with silicide formed between the contact and the source or drain.
FIG. 3 is perspective view of a cross-section of a contact over a source or drain, where the contact has a barrier region, according to some embodiments of the present disclosure.
FIG. 4 is cross-sectional view of a carbon-metal barrier region, according to some embodiments of the present disclosure.
FIG. 5 is cross-sectional view of a carbon-metal barrier with a metal carbide layer, according to some embodiments of the present disclosure.
FIG. 6 is cross-sectional view of a carbon-metal-carbon barrier region, according to some embodiments of the present disclosure.
FIG. 7 is cross-sectional view of a carbon-metal-carbon barrier with two metal carbide layers, according to some embodiments of the present disclosure.
FIG. 8 is cross-sectional view of a carbon-metal-carbon barrier with three metal carbide layers, according to some embodiments of the present disclosure.
FIGS. 9A-9B are perspective and cross-sectional views, respectively, of an example transistor implemented as a FinFET with source and drain contacts with metal and carbon barrier regions, according to some embodiments of the present disclosure.
FIG. 10 is a flowchart illustrating a method for forming source and drain contacts with metal and carbon barrier regions, according to some embodiments of the present disclosure.
FIGS. 11A and 11B are top views of a wafer and dies that include contacts with metal and carbon barrier regions in accordance with any of the embodiments disclosed herein.
FIG. 12 is a cross-sectional side view of an IC device that may include contacts with metal and carbon barrier regions in accordance with any of the embodiments disclosed herein.
FIG. 13 is a cross-sectional side view of an IC device assembly that may include contacts with metal and carbon barrier regions in accordance with any of the embodiments disclosed herein.
FIG. 14 is a block diagram of an example computing device that may include contacts with metal and carbon barrier regions in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices that source and drain contacts with an inner conductive structure and a barrier region, and methods for producing such devices. An IC device includes various circuit elements, such as transistors and capacitors, coupled together by metal interconnects. The circuit elements typically include semiconductor materials that are coupled to the interconnects by contacts, also referred to as electrodes.

One example IC device includes memory cells for storing bits of data. A memory cell may include a capacitor for storing a bit value or a memory state (e.g., logical "1" or "0") of the cell, and an access transistor controlling access to the cell (e.g., access to write information to the cell or access to read information from the cell). Such a memory cell may be referred to as a "1T-1C memory cell," highlighting the fact that it uses one transistor (i.e., "1T" in the term "1T-1C memory cell") and one capacitor (i.e., "1C" in the term "1T-1C memory cell"). The capacitor of a 1T-1C memory cell may be coupled to one source or drain (S/D) region/terminal of the access transistor (e.g., to the source region of the access transistor) by a first S/D contact, while the other S/D region of the access transistor may be coupled to a bitline (BL) by a second S/D contact, and a gate terminal of the transistor may be coupled to a word-line (WL) by a gate contact. Various 1T-1C memory cells have, conventionally, been implemented with access transistors being front end of line (FEOL), logic-process based, transistors implemented in an upper-most layer of a semiconductor substrate.

Transistors, such as the access transistor of the memory cell described above, include a channel material in which two S/D regions are formed. The channel material is typically a semiconductor, such as silicon (Si). Various different semiconductor materials have been used as transistor channel materials, such as germanium, indium antimonide, lead telluride, indium arsenide, indium phosphide, gallium arsenide, indium gallium arsenide, gallium antimonide, or other combinations of group III-V, group II-VI, or group IV materials. Portions of the channel region may be highly doped to form the S/D regions.

Common source and drain (S/D) contacts for semiconductor devices include one or more metals, such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. For example, titanium (Ti) and titanium nitride (TiN) are commonly used to form S/D contacts.

When previous S/D contact materials, such as Ti and TiN, are used in combination with silicon or silicon-based channels, the contact material and Si interact and form a silicide. For example, Ti contacts react with Si S/D regions to form titanium silicide (TiSi₂). The silicide creates a interfacial layer between the S/D regions and contacts, which is undesirable. Silicides have a relatively high Schottky barrier height, e.g., TiSi₂ has a Schottky barrier height of around 0.55 eV. It is desirable to reduce the Schottky barrier height between the S/D region and the contact.

The barrier regions described herein reduce the Schottky barrier height between Si S/D regions and the S/D contacts. The barrier region includes carbon and a metal, such as niobium (Nb), tantalum (Ta), aluminum (Al), or titanium (Ti). The barrier region prevents the formation of TiSi₂ by physically separating the Si S/D from the Ti or TiN contact material. In addition, the carbon and metal barrier regions have a lower Schottky barrier height (<0.55 eV) compared to TiSi₂. For example, the Schottky barrier height of the barrier regions disclosed herein may be in the range of 0.30 eV to 0.47 eV.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### Example memory cell with S/D contacts

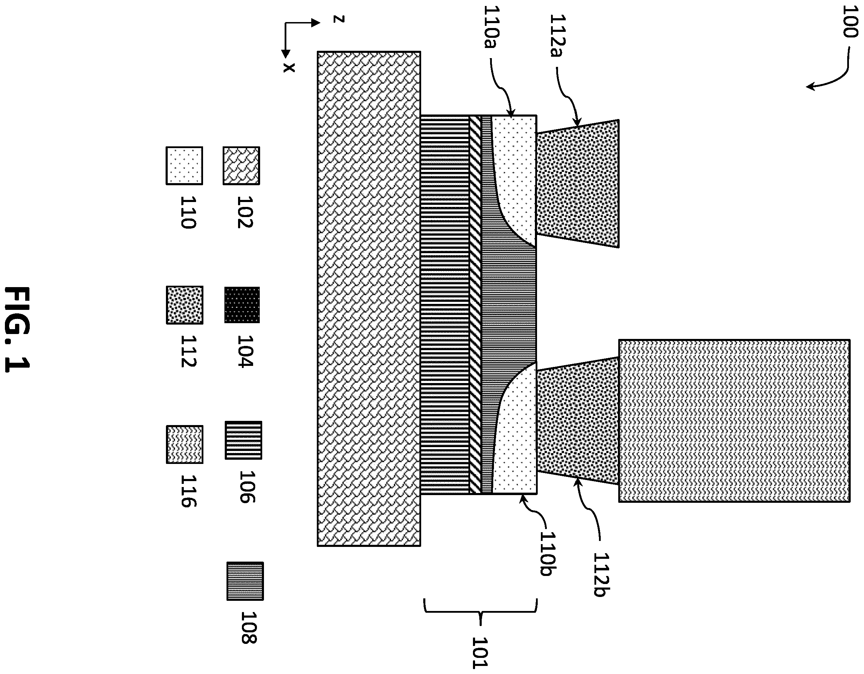

FIG. 1 is a cross-sectional view showing an example arrangement of a one transistor one capacitor (1T-1C) memory cell 100 with source and drain contacts, according to some embodiments of the present disclosure.

The 1T-1C memory cell 100 is formed over a support structure 102. The 1T-1C memory cell 100 includes a transistor 101 coupled to a pair of S/D contacts 112a and 112b, where the S/D contacts 112 include a barrier region not specifically shown in FIG. 1. One of the S/D contacts 112b is coupled to a capacitor 116 for storing a bit of data. The transistor 101 is an access transistor that controls access to the capacitor 116 to write information to the capacitor 116 or to read information from the capacitor 116. A number of elements referred to in the description of FIGs. 1-8 with reference numerals are illustrated in these figures with different patterns, with a legend showing the correspondence between the reference numerals and patterns being provided at the bottom or side of each drawing page containing FIGs. 1-8. For example, the legend in FIG. 1 illustrates that FIG. 1 uses different patterns to show a support structure 102, a gate electrode 104, a gate dielectric 106, a channel material 108, S/D regions 110, S/D contacts 112, and the capacitor 116.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

The transistor 101 includes a gate electrode 104, a gate dielectric 106, a channel material 108, and two S/D regions 110. The gate electrode 104 may be coupled to a WL, e.g., via a gate via not specifically shown in FIG. 1. The WL may be coupled to a row of similar memory cells. A first S/D region 110a is coupled to a first S/D contact 112a, and a second S/D region 110b is coupled to a second S/D contact 112b. The first S/D contact 112a may be coupled to a BL that is coupled to a column of similar memory cells. The second S/D contact 112a is coupled to one electrode of a capacitor 116. The capacitor 116 may have a second electrode coupled to a plateline (PL), not shown in FIG. 1, as is known in the art.

In general, implementations of the present disclosure may be formed or carried out on a support structure 102, such as a semiconductor substrate composed of semiconductor material systems, and in particular, N-type material systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which a semiconductor device may be built falls within the spirit and scope of the present disclosure. In various embodiments the support structure 102 may include any such substrate that provides a suitable surface for providing the memory cell shown in FIG. 1.

The transistor 101 is formed over the support structure 102. The gate electrode 104 and the gate dielectric 106 form a gate stack. The gate electrode 104 may include at least one N-type work function metal, and the transistor 101 is an NMOS transistor. For an NMOS transistor, metals that may be used for the gate electrode 104 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). Other materials that may be used include titanium nitride, tantalum nitride, hafnium nitride, tungsten, iridium, copper, or degenerately doped poly-silicon. In some embodiments, the gate electrode 104 may consist of a stack of two or more metal layers, where one or more metal layers are work function metal layers and at least one metal layer is a fill metal layer. Further layers may be included next to the gate electrode 104 for other purposes, such as to act as a diffusion barrier layer or/and an adhesion layer.

In some embodiments, the gate dielectric 106 may include one or more high-k dielectrics. Examples of high-k materials that may be used in the gate dielectric 106 may include, but are not limited to, hafnium oxide, hafnium silicon oxide, lanthanum oxide, lanthanum aluminum oxide, zirconium oxide, zirconium silicon oxide, silicon oxide, tungsten oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, lead zinc niobate, aluminum nitride, and silicon nitride. In some embodiments, the gate dielectric 106 may consist of a stack of two or more dielectric layers, e.g., a stack of two or more of the high-k materials listed above. The gate dielectric 106, or a layer of the gate dielectric 106, may comprise a mixture of the materials listed above and/or of other oxides, nitrides, or oxynitrides.

The gate dielectric 106 may be deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In some embodiments, an annealing process may be carried out on the gate dielectric 106 during manufacture of the transistor 101 to improve the quality of the gate dielectric 106. The gate dielectric 106 may have a thickness, a dimension measured in the direction of the z-axis of the reference coordinate system x-y-z shown in FIG. 1, that may, in some embodiments, be between 0.5 nanometers and 20 nanometers, including all values and ranges therein (e.g., between 2 and 6 nanometers).

The channel material 108 may be composed of semiconductor material systems and in particular, N-type materials systems. In certain embodiments, the channel material 108 is silicon or includes silicon, e.g., N-type amorphous or polycrystalline silicon, or monocrystalline silicon.

In some embodiments, the transistor 101 may be a thin film transistor (TFT). A TFT is a special kind of a field-effect transistor made by depositing a thin film of an active semiconductor material, as well as a dielectric layer and metallic contacts, over a supporting layer that may be a non-conducting layer. At least a portion of the active semiconductor material forms a channel of the TFT. In some embodiments, the channel material 108 may have a thickness between about 5 and 75 nanometers, including all values and ranges therein. In some embodiments, a thin film channel material 108 may be deposited at relatively low temperatures, which allows depositing the channel material 108 within the thermal budgets imposed on back end fabrication to avoid damaging other components, e.g., front end components such as the logic devices.

The S/D regions 110 are formed in the channel material 108. The S/D regions 110 may generally be formed using either an implantation/diffusion process or an etching/deposition process. In the former process, dopants such as boron, aluminum, antimony, phosphorous, or arsenic may be ion-implanted into the channel material to form the S/D regions 110. An annealing process that activates the dopants and causes them to diffuse further into the channel material 108 typically follows the ion implantation process. In the latter process, the channel material 108 may first be etched to form recesses at the locations of the S/D regions 110. An epitaxial deposition process may then be carried out to fill the recesses with material that is used to fabricate the S/D regions 110. In some implementations, the S/D regions 110 may be fabricated using a silicon alloy such as silicon germanium or silicon carbide. In some implementations, the epitaxially deposited silicon alloy may be doped in situ with dopants such as boron, arsenic, or phosphorous.

The S/D contacts 112 are coupled to the channel material 108, and in particular, to the S/D regions 110. The first S/D contact 112a is coupled to the first S/D region 110a, and the second S/D contact 112b is coupled to the second S/D region 110b. An insulator material (not shown in FIG. 1) may be formed between the S/D contacts 112 and electrically separate the two S/D contacts 112a and 112b. The insulator material may be formed as a layer over the transistor 101 and similar transistors, where the insulator material layer further electrically separates transistors from one another. The S/D contacts 112 may be formed in the insulator material by patterning the S/D contacts 112 in the insulator layer and depositing the S/D contact material in the patterned regions.

The S/D contacts 112 include an inner conductive structure that is surrounded by a barrier region. The barrier region separates the inner conductive structure, which may include titanium, from the S/D regions 110, which may include silicon. The barrier region prevents the formation of titanium silicide, which creates resistivity between the S/D contacts 112 and the S/D region 110. As noted above, the barrier region may include carbon and a metal, e.g., a layer of carbon and a layer of a metal, such as Nb, Ta, Al, or Ti. The barrier region is selected to have a relatively low Schottky barrier height, e.g., less than 0.55 eV.

The S/D contacts 112 may have a thickness measured in the z-direction in the reference coordinate system shown in FIG. 1 of between 1 nanometers and 50 nanometers, including all values and ranges therein. In some embodiments, the S/D contacts 112 have a thickness between 30 and 40 nanometers.

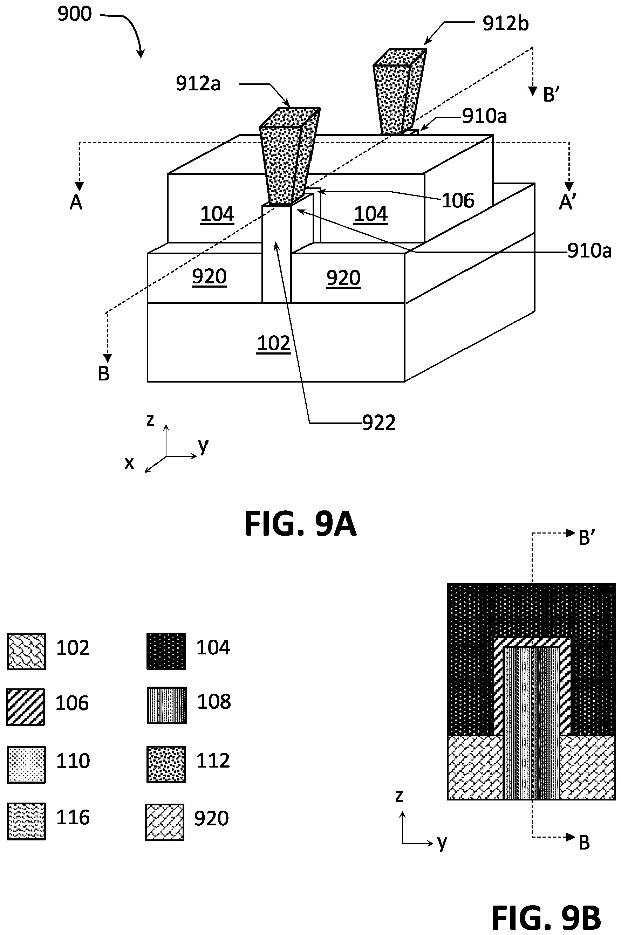

While the transistor 101 depicted in FIG. 1 has a back-side gate stack and front-side S/D contacts, in other embodiments, different transistor architectures may include the S/D contacts with barrier regions described herein. For example, the gate stack may be on the front-side, or one or both of the S/D regions and S/D contacts may be on the back-side. In other embodiments, the transistors may have a non-planar architecture, such as a FinFET. An example of a FinFET is shown in FIGs. 9A and 9B. In some embodiments, the transistor is a nanoribbon-based transistor (or, simply, a nanoribbon transistor, e.g., a nanowire transistor). In a nanoribbon transistor, a gate stack that may include a stack of one or more gate electrode metals (e.g., the materials discussed with respect to the gate electrode 104) and, optionally, a stack of one or more gate dielectrics (e.g., one of the gate dielectrics 106) may be provided around a portion of an elongated semiconductor structure called "nanoribbon", forming a gate on all sides of the nanoribbon. The portion of the nanoribbon around which the gate stack wraps around is referred to as a "channel" or a "channel portion," and may be formed of any of the channel materials 108 described above, and in particular, an oxide-metal channel material. The S/D regions are provided on the opposite ends of the nanoribbon, on either side of the gate stack, forming, respectively, a source and a drain of such a transistor.

The 1T-1C memory cell shown in FIG. 1 is just one example IC device that may include S/D contacts with barrier regions. As another example, the capacitor may not be formed, resulting in a transistor with contacts having barrier regions.

### Example S/D contact with silicide formation

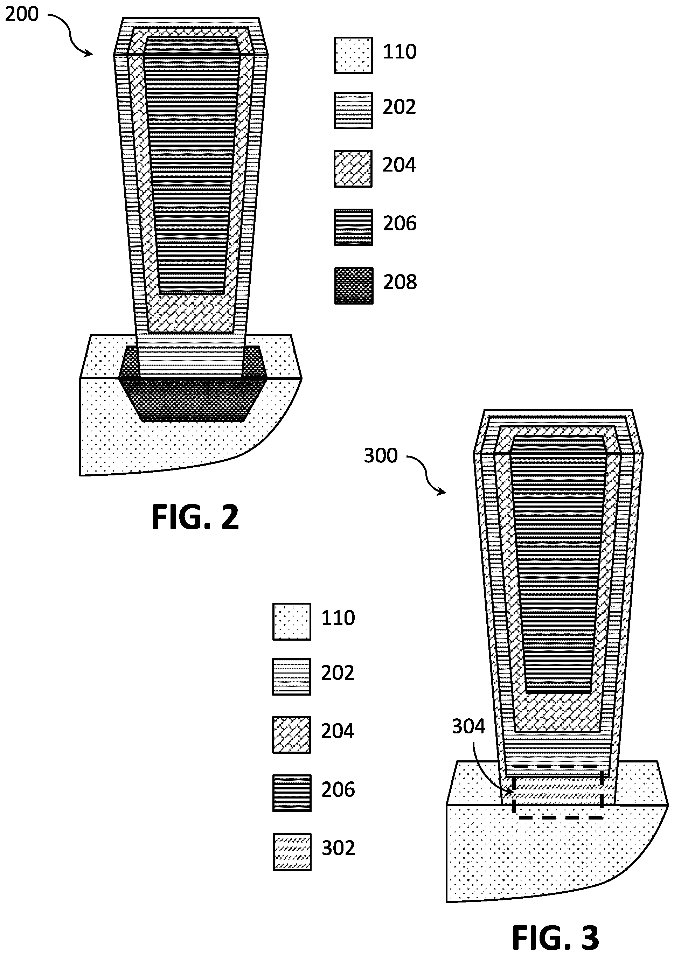

FIG. 2 is perspective view of a cross-section of a contact over a source or drain with silicide formed between the contact and the source or drain. FIG. 2 illustrates one of the S/D regions 110 and a contact 200 formed over the S/D region 110. In this example, the S/D region 110 includes silicon. The contact 200 includes multiple layers, such as a Ti layer 202, a TiN layer 204, and a core 206. Alternatively, the Ti layer 202 or TiN layer 204 may not be present. The core 206 may be formed from one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the core 206 may include one or more electrically conductive alloys, oxides, or carbides of one or more metals. In some embodiments, the core 206 may include a doped semiconductor, such as silicon or another semiconductor doped with an N-type dopant. Metals may provide higher conductivity, while doped semiconductors may be easier to pattern during fabrication.

In this example, the Ti layer 202 is formed directly over the S/D region 110. Titanium reacts with the silicon in the S/D region 110, forming an interfacial layer of titanium silicide 208. As noted above, TiSi₂ has a Schottky barrier height of around 0.55 eV. If other materials are used instead of the Ti layer 202, different metal silicides may be formed.

### Example S/D contact with barrier region

FIG. 3 is perspective view of a cross-section of a contact over a source or drain, where the contact has a barrier region, according to some embodiments of the present disclosure. FIG. 3 illustrates one of the S/D regions 110 with a contact 300 formed over the S/D region 110. The S/D region 110 may include silicon. The contact 300 includes a barrier region 302 and an inner conductive structure. In this example, the inner conductive structure includes a Ti layer 202, a TiN layer 204, and a core 206. In other embodiments, the inner conductive structure may include more, fewer, or different layers, and may include different materials. For example, the Ti layer 202 or TiN layer 204 may not be present. The core 206 may be formed from any of the materials described with respect to FIG. 2.

The barrier region 302 has lower resistivity and a lower Schottky barrier height than the silicide region 208 shown in FIG. 3. The barrier region 302 may include carbon in combination with one or more other metals, such as Nb, Ta, Al, or Ti. The barrier region 302 may include multiple layers, e.g., one or more carbon layers, and one or more metal layers.

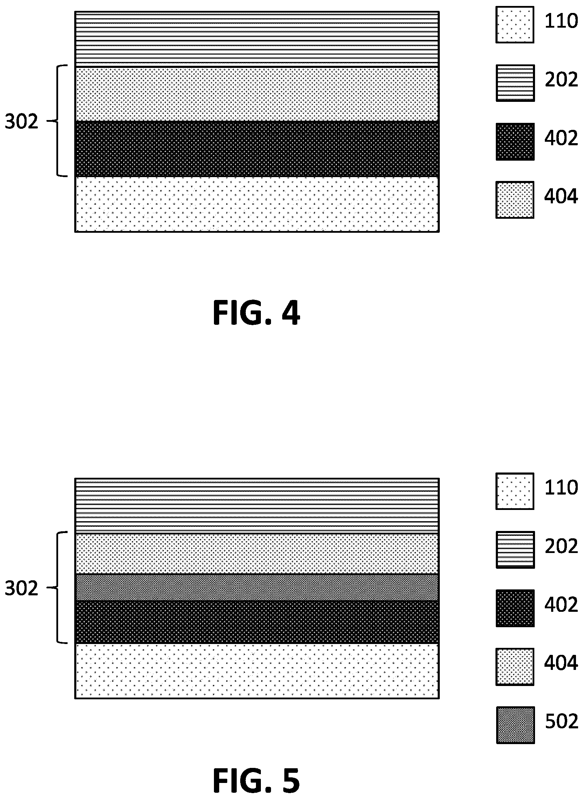

The barrier region 302 is coupled between the S/D region 110 and the inner conductive structure. The barrier region 302 may have thickness between 0.25 nanometers to 2.5 nanometers. In the example shown in FIG. 3, the barrier region 302 and each layer 202, 204, and 206 of the inner conductive structure reach a same height. For example, the barrier region 302 and the layers 202 and 204 may be formed using a conformal deposition method, such as ALD or CVD, to deposit the barrier region 302 and layers 202 and 204 in an opening formed in an insulating material (e.g., ILD), not shown in FIG. 3. If the barrier region 302 includes multiple layers (e.g., one or more carbon layers and one or more metal layers), each individual layer may extend across the base of the contact 300 and up the height of the contact 300. Example layers for forming the barrier region 302 are illustrated in FIGs. 4-8. In particular, each of FIGs. 4-8 illustrates an example structure for the region 304 within the dashed box.

In some embodiments, the barrier region 302 (or one or more individual layers of the barrier region 302) and/or the layers 202 and 204 may not extend up the full height of the contact 300. For example, the barrier region 302 may be formed over the S/D region 110, and the inner conductive structure (e.g., the Ti layer 202, TiN layer 204, and core 206) is formed over top of the barrier region 302. In this example, the barrier region 302 may be deposited using a non-conformal deposition method, such as sputtering. If the barrier region 302 is deposited using a non-conformal deposition method, some of the material forming the barrier region 302 may be formed along the sides of the contact 300, e.g., as illustrated in FIG. 3.

While FIG. 3 illustrates one contact 300 over one S/D region 110, a similar contact 300 may be formed over both S/D regions 110 of a transistor, e.g., both the S/D contact 112a and the S/D contact 112b may have the structure of the contact 300 shown in FIG. 3.

### Example layered barrier regions

FIGs. 4-8 illustrate various layer structures for the barrier region 302. The layered structures illustrate details of the barrier region 302 within the region 304 shown in FIG. 3.

FIG. 4 is cross-sectional view of a carbon-metal barrier region, according to some embodiments of the present disclosure. The barrier region 302 includes a carbon layer 402 and a metal layer 404. The S/D region 110 is below the carbon layer 402, and the titanium layer 202 (or, more generally, the inner conductive structure) is above the metal layer 404.

The carbon layer 402 may include graphite-like carbon, diamond-like carbon, or a mixture of graphite-like carbon and diamond-like carbon. Graphite-like carbon is a crystalline form of carbon with atoms arranged in a hexagonal structure. Graphite-like carbon may include of layers of two-dimensional sheets formed from carbon atoms; the single-layer sheets are referred to as graphene. Graphite-like carbon is a good conductor of heat and electricity, making it suitable for use as an S/D contact. Diamond-like carbon is a class of carbon that may have one of seven structures, including a cubic lattice or hexagonal lattice. Diamond-like carbon typically includes significant amounts of sp³ hybridized carbon atoms. Different forms of diamond-like carbon have different levels of conductivity, with some forms acting as semiconductors and others as insulators.

The carbon layer 402 may include pure or nearly pure graphite-like carbon or diamond-like carbon. In other embodiments, the carbon layer 402 may include a mixture of graphite-like carbon and diamond-like carbon, e.g., anywhere in the range of a 1:20 ratio of graphite-like carbon to diamond-like carbon to a 20:1 ratio of graphite-like carbon to diamond-like carbon. The carbon layer 402 may be deposited using a non-conformal deposition method, such as physical vapor deposition (PVD) magnetron sputtering. Different parameters of the PVD magnetron sputtering process (e.g., temperature, bias, power, and throw distance) may be tuned to achieve diamond-like carbon, graphite-like carbon, or a desired ratio of diamond-like carbon to graphite-like carbon.

The carbon layer 402 may have a thickness between, e.g., 0.125 nanometers to 2 nanometers. In some embodiments, the metal layer 404 is omitted, and the titanium layer 202 is a metal layer over the carbon layer 402. In such embodiments, the carbon layer 402 may have a thickness up to 2.5 nanometers.

As noted above, the metal layer 404 may include Nb, Ta, or Al. In some embodiments, the metal layer 404 may include multiple metals. In some embodiments, the metal layer 404 is made up of multiple metal layers, e.g., one layer of Nb and one layer of Ta. The metal layer 404 may be formed using a conformal or non-conformal deposition method. The metal layer 404 may have a thickness between, e.g., 0.125 to 2 nanometers. As noted above, the total thickness of the carbon layer 402 and the metal layer 404 (i.e., the total thickness of the barrier region 302) may be between 0.25 and 2.5 nanometers.

FIG. 5 is cross-sectional view of a carbon-metal barrier with a metal carbide layer, according to some embodiments of the present disclosure. In this example, metal in the metal layer 404 has reacted with carbon in the carbon layer 402, forming a metal carbide layer 502 between the carbon layer 402 and the metal layer 404. For example, if the metal layer 404 includes Nb, the metal carbide layer 502 includes niobium carbide. If the metal layer 404 is titanium (e.g., if the titanium layer 202 is the metal layer directly over the carbon layer 402), the metal carbide layer 502 includes titanium carbide. The metal carbides formed by the metal layer 404 and carbon layer 402 are typically conductive and do not increase resistivity of the barrier region 302.

Depending on the thicknesses of the carbon layer 402 and the metal layer 404, some portion of the carbon layer 402 and/or portion of the metal layer 404 may remain, as illustrated in FIG. 5. The metal carbide layer 502 may have a thickness between 0 nanometers (if no metal carbide is formed) and 2.5 nanometers (e.g., if the total height of the barrier region 302 is 2.5 nanometers, and the full carbon layer 402 and full metal layer 404 react), or anywhere therebetween.

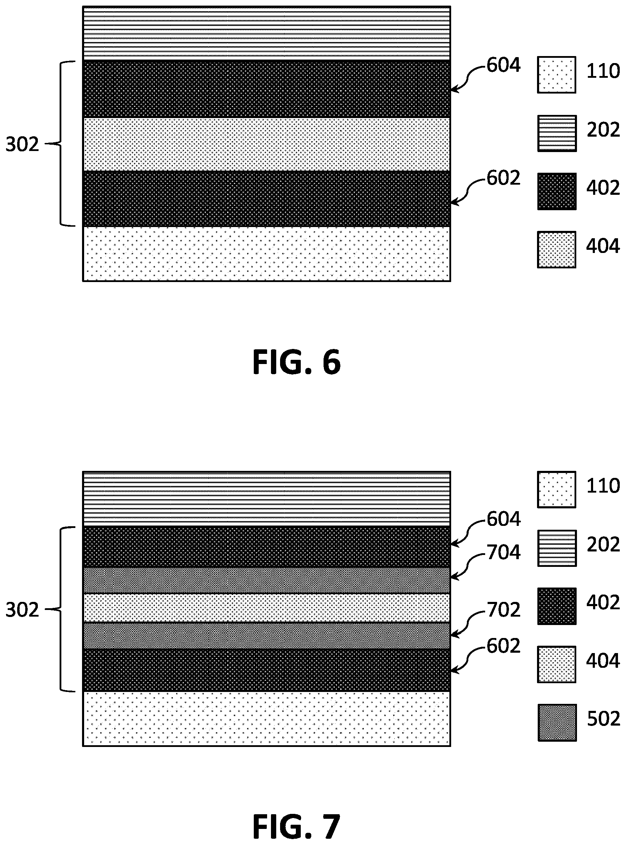

FIG. 6 is cross-sectional view of a carbon-metal-carbon barrier region, according to some embodiments of the present disclosure. The barrier region 302 includes a first carbon layer 602, a metal layer 404, and a second carbon layer 604. The first carbon layer 602 is between the S/D region 110 and the metal layer 404, the metal layer 404 is between the two carbon layers 602 and 604, and the second carbon layer 604 is between the metal layer 404 and the titanium layer 202 (or, more generally, the inner conductive structure). As noted above, the metal layer 404 may include Nb, Ta, Al, or Ti. In some embodiments, the metal layer 404 may include multiple metals. In some embodiments, the metal layer 404 is made up of multiple metal layers, e.g., one layer of Nb and one layer of Ta.

The first carbon layer 602 may have a thickness between, for example, 0.1 nanometers and 1 nanometer. The metal layer 404 may have a thickness between, for example, 0.1 nanometers and 1.5 nanometers. The second carbon layer 602 may have a thickness between, for example, 0.1 nanometers and 1 nanometer. The total thickness of the carbon layers 602 and 604 and the metal layer 404 (i.e., the total thickness of the barrier region 302) may be between 0.25 and 2.5 nanometers.

As with the carbon-metal barrier region and described with respect to FIG. 5, the metal layer 404 may react with one or both of the carbon layers 602 and 604, forming metal carbide layers. FIG. 7 is cross-sectional view of a carbon-metal-carbon barrier with two metal carbide layers, according to some embodiments of the present disclosure. A first metal carbide layer 702 is between the first carbon layer 602 and the metal layer 404, and a second metal carbide layer 704 is between the metal layer 404 and the second carbon layer 604. The first metal carbide layer 702 may have a thickness between 0 nanometers (if no metal carbide is formed) and 1.25 nanometers (e.g., if the total height of the barrier region 302 is 2.5 nanometers, and the full carbon layer 602 and full lower portion of the metal layer 404 reacts), or anywhere therebetween. The second metal carbide layer 704 may have a thickness between 0 nanometers (if no metal carbide is formed) and 1.25 nanometers (e.g., if the total height of the barrier region 302 is 2.5 nanometers, and the full carbon layer 604 and full upper portion of the metal layer 404 reacts).

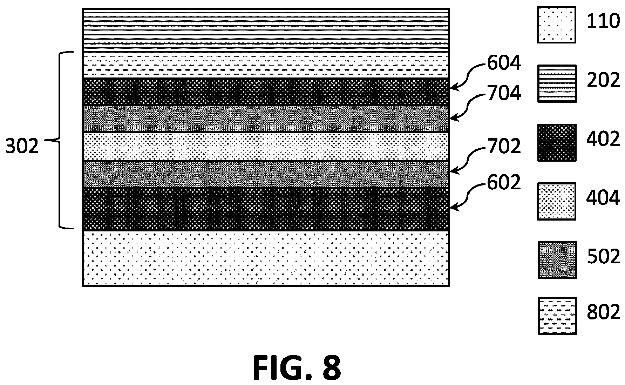

In some cases, the second carbon layer 604 may also react with the inner conductive structure formed over the second carbon layer 604. For example, if the bottom layer of the inner conductive structure includes titanium, the titanium may react with carbon in the second carbon layer 604, forming titanium carbide. FIG. 8 is cross-sectional view of a carbon-metal-carbon barrier with three metal carbide layers, according to some embodiments of the present disclosure. In this example, a titanium carbide layer 802 is formed between the second carbon layer 604 and the titanium layer 202. The titanium carbide layer 802 may have a thickness between, for example, 0.125 nanometers and 1.25 nanometers.

### FinFET arrangement with S/D contacts with barrier regions

As noted above, while the transistor 101 depicted in FIG. 1 has a back-side gate stack and front-side S/D contacts, in other embodiments, different transistor architectures may include the S/D contacts with barrier regions described herein. For example, in some embodiments, the contacts with barrier regions are used in transistors with a non-planar architecture, such as a FinFET.

FIGS. 9A-9B are perspective and cross-sectional views, respectively, of an example transistor implemented as a FinFET with contacts with metal and carbon barrier regions, according to some embodiments of the present disclosure. FinFETs refer to transistors having a non-planar architecture where a fin, formed of one or more semiconductor materials, extends away from a base (where the term "base" refers to any suitable support structure on which a transistor may be built, e.g., a substrate). A portion of the fin that is closest to the base may be enclosed by an insulator material. Such an insulator material, typically an oxide, is commonly referred to as a "shallow trench isolation" (STI), and the portion of the fin enclosed by the STI is typically referred to as a "subfin portion" or simply a "subfin." A gate stack that includes at least a layer of a gate electrode material and, optionally, a layer of a gate dielectric may be provided over the top and sides of the remaining upper portion of the fin (i.e., the portion above and not enclosed by the STI), thus wrapping around the upper-most portion of the fin. The portion of the fin over which the gate stack wraps around is typically referred to as a "channel portion" of the fin because this is where, during operation of the transistor, a conductive channel forms, and is a part of an active region of the fin. Two S/D regions are provided on the opposite sides of the gate stack, forming a source and a drain terminal of a transistor. FinFETs may be implemented as "tri-gate transistors," where the name "tri-gate" originates from the fact that, in use, such transistors may form conducting channels on three "sides" of the fin. FinFETs potentially improve performance relative to single-gate transistors and double-gate transistors.

FIG. 9A is a perspective view, while FIG. 9B is a cross-sectional side view of a FinFET 900 with metal and carbon barrier regions in the S/D contacts. FIGS. 9A-9B illustrate the support structure 102, gate electrode 104, gate dielectric 106, channel material 108, and S/D regions 110 as described with respect to FIG. 1. The two S/D regions are labeled as 910a and 910b in FIG. 9A. As shown in FIGS. 9A-9B, when the transistor 900 is implemented as a FinFET, the FinFET 900 may further a fin 922, and an STI material 920 enclosing the subfin portion of the fin 922. Two S/D contacts 912a and 912b are further shown in FIGS. 9A-9B. The contacts 912a and 912b may incorporate any of the barrier regions 302 described with respect to FIGs. 3-8. The cross-sectional side view of FIG. 9B is the view in the y-z plane of the example coordinate system x-y-z shown in FIG. 9A, with the cross-section of FIG. 9B taken across the fin 922 (e.g., along the plane shown in FIG. 9A as a plane AA').

As shown in FIGS. 9A-9B, the fin 922 may extend away from the support structure 102 and may be substantially perpendicular to the support structure 102. The fin 904 may include one or more semiconductor materials, e.g. a stack of semiconductor materials, so that the upper-most portion of the fin (namely, the portion of the fin 922 enclosed by the gate electrode 104 and gate dielectric 106) may serve as the channel region of the FinFET 900. Therefore, the upper-most portion of the fin 922 may be formed of the channel material 108 as described above.

The subfin of the fin 922 may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth. For some example N-type transistor embodiments, the subfin portion of the fin 922 may be a III-V material having a band offset (e.g., conduction band offset for N-type devices) from the channel portion. Example materials, include, but are not limited to, GaAs, GaSb, GaAsSb, GaP, InAIAs, GaAsSb, AlAs, AlP, AlSb, and AlGaAs. In some N-type transistor embodiments of the FinFET 900 where the channel portion of the fin 922 (e.g., the channel portion) is InGaAs, the subfin may be GaAs, and at least a portion of the subfin may also be doped with impurities (e.g., P-type) to a greater impurity level than the channel portion. In an alternate heterojunction embodiment, the subfin and the channel portion of the fin 922 are each, or include, group IV semiconductors (e.g., Si, Ge, SiGe). The subfin of the fin 922 may be a first elemental semiconductor (e.g., Si or Ge) or a first SiGe alloy (e.g., having a wide bandgap).

As further shown in FIGS. 9A-9B, the STI material 920 may enclose portions of the sides of the fin 922. A portion of the fin 922 enclosed by the STI 920 forms a subfin. In various embodiments, the STI material 920 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 920 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

The gate stack (i.e., the gate dielectric 106 and gate electrode 104) may wrap around the upper portion of the fin 922 (the portion above the STI 920), as shown in FIGS. 9A-9B, with a channel portion of the fin 922 corresponding to the portion of the fin 922 wrapped by the gate stack as shown in FIGS. 9A-9B. In particular, the gate dielectric 106 (if used) may wrap around the upper-most portion of the fin 922, and the gate electrode 104 may wrap around the gate dielectric 106. The interface between the channel portion and the subfin portion of the fin 922 is located proximate to where the gate electrode 104 ends.

In some embodiments, the FinFET 900 may have a gate length, GL, (i.e. a distance between the first S/D region 910a and the second S/D region 910b), a dimension measured along the fin 922 in the direction of the x-axis of the example reference coordinate system x-y-z shown in FIGS. 9A-9B, which may, in some embodiments, be between about 5 and 40 nanometers, including all values and ranges therein (e.g. between about 22 and 35 nanometers, or between about 20 and 30 nanometers). The fin 922 may have a thickness, a dimension measured in the direction of the y-axis of the reference coordinate system x-y-z shown in FIGS. 9A-9B, that may, in some embodiments, be between about 5 and 30 nanometers, including all values and ranges therein (e.g. between about 7 and 20 nanometers, or between about 10 and 15 nanometers). The fin 922 may have a height, a dimension measured in the direction of the z-axis of the reference coordinate system x-y-z shown in FIGS. 9A-9B, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 922 illustrated in FIGS. 9A-9B is shown as having a rectangular cross-section in a y-z plane of the reference coordinate system shown, the fin 922 may instead have a cross-section that is rounded or sloped at the "top" of the fin 922, and the gate stack may conform to this rounded or sloped fin 922. In use, the FinFET 900 may form conducting channels on three "sides" of the channel portion of the fin 922, potentially improving performance relative to single-gate transistors (which may form conducting channels on one "side" of a channel material or substrate) and double-gate transistors (which may form conducting channels on two "sides" of a channel material or substrate).

The S/D contacts 912a and 912b are electrically connected to the S/D regions 910a and 910b and extend in the same vertical direction with respect to the fin 922. In another example, one of the S/D contacts (e.g., the first S/D contact 912a) may be electrically connected to the first S/D region 910a and extend from the first S/D region 910a towards the support structure 102, thus forming a back-side S/D contact for the FinFET 900. In still another implementation, both the first S/D contact 912a and the second S/D contact 912b extend from the first and second S/D region 910a and 910b towards the support structure, thus forming two back-side S/D contacts for the FinFET 900.

### Example method for forming S/D contacts with barrier region

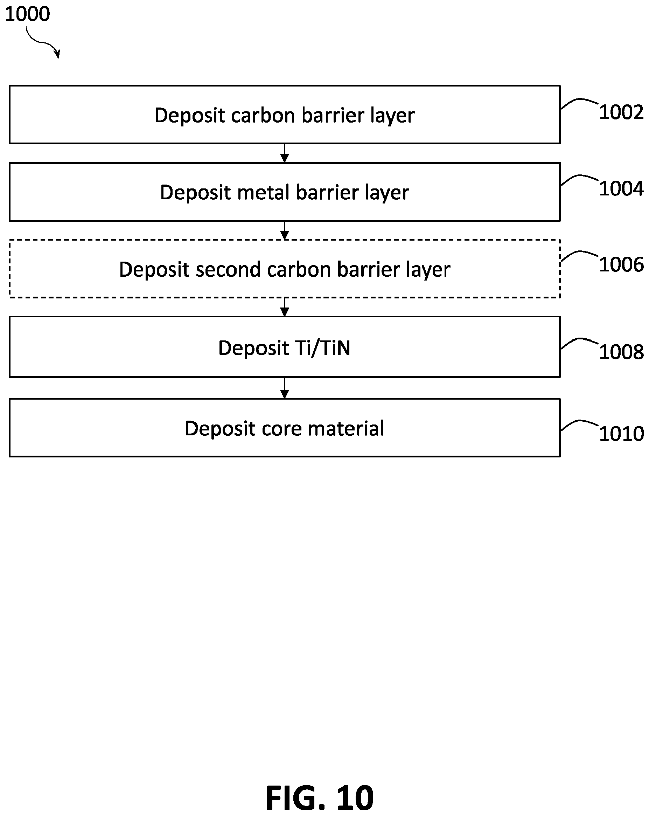

FIG. 10 is a flowchart illustrating a method for forming source and drain contacts with metal and carbon barrier regions, according to some embodiments of the present disclosure. The method begins with depositing 1002 a carbon barrier layer, e.g., the carbon layer 402 shown in FIG. 4, or the first carbon layer 602 shown in FIG. 6. The carbon layer 402 is deposited over a S/D region, e.g., the S/D region 110.

The method proceeds with depositing 1004 a metal barrier layer, e.g., the metal layer 404 shown in FIG. 4, or the metal layer 404 shown in FIG. 6. In some embodiments, multiple metal layers (e.g., a niobium layer followed by an aluminum layer) are deposited. The metal in the metal barrier layer may react with carbon in the carbon layer forming a metal carbide, as illustrated in FIGs. 5, 7, and 8.

In some embodiments, the method proceeds with depositing 1006 a second carbon barrier layer, e.g., the second carbon layer 604 shown in FIG. 6. Carbon in the second carbon barrier layer may react with metal in the metal barrier layer, forming a metal carbide, as illustrated in FIGs. 7 and 8. In other embodiments, a second carbon barrier layer is not deposited (e.g., as shown in FIGs. 4 and 5). The carbon barrier layer, metal barrier layer, and optional second carbon barrier layer form a barrier region.

The method proceeds with depositing 1008 a Ti and/or TiN layer over the barrier region. For example, as illustrated in FIG. 3, a Ti layer is deposited, followed by a TiN layer. If a second carbon barrier layer was deposited, Ti may react with carbon in the second carbon barrier layer, forming titanium carbide, as illustrated in FIG. 8. In alternate embodiments, different conductive materials are used instead of Ti and/or TiN.

The method proceeds with depositing 1010 a core material over the Ti/TiN layers. FIG. 3 illustrates the core 206. The core material fills the inner portion of the S/D contact.

### Example devices

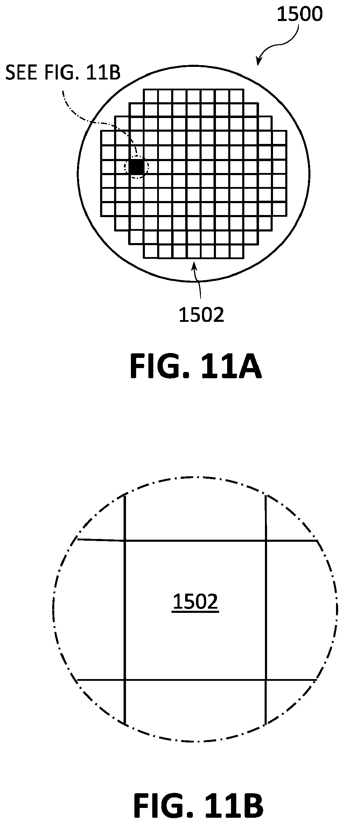

The interconnects with barrier material liners disclosed herein may be included in any suitable electronic device. FIGS. 11-14 illustrate various examples of apparatuses that may include the contacts with carbon and metal barrier regions disclosed herein.

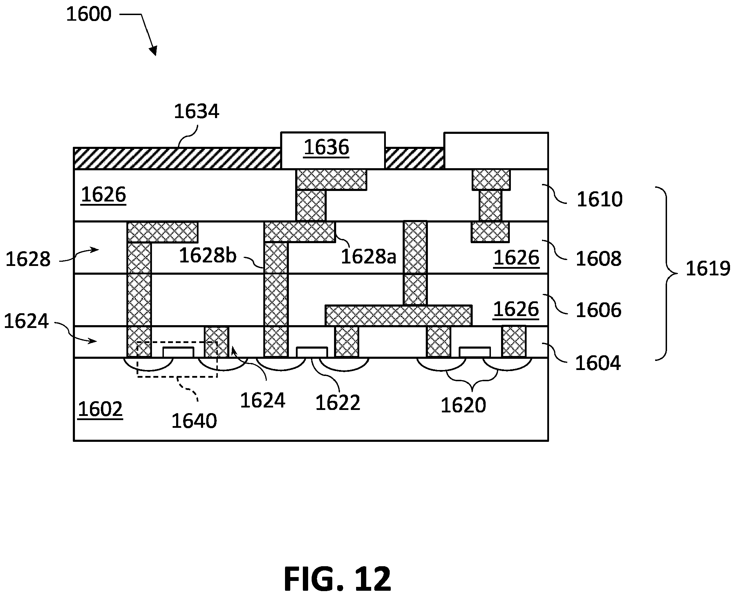

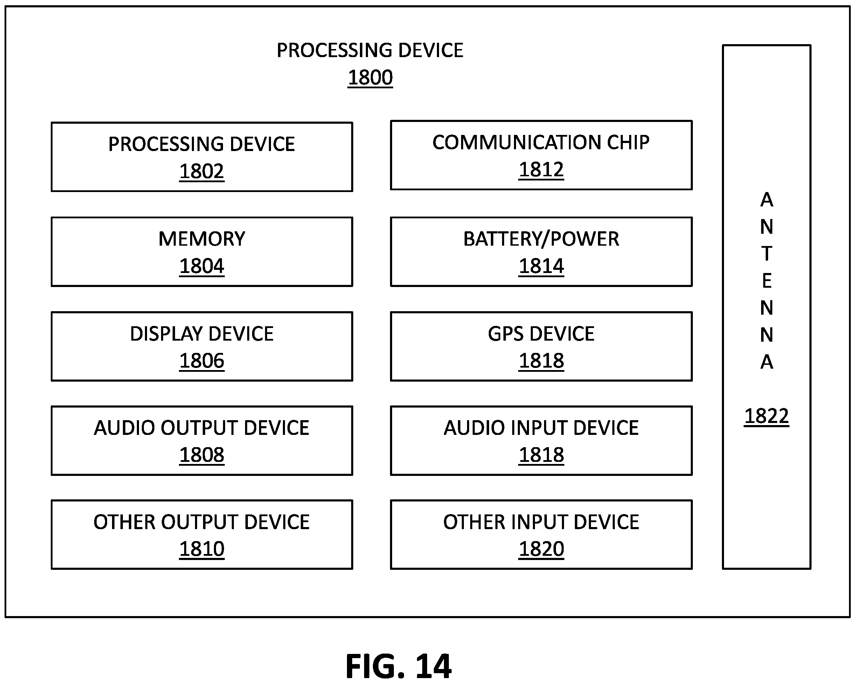

FIG. 11A and 11B are top views of a wafer and dies that include one or more IC structures with one or more contacts with carbon and metal barrier regions in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1-9, or any further embodiments of the IC structures described herein). After the fabrication of the semiconductor product is complete (e.g., after manufacture of one or more IC structures with one or more contacts with carbon and metal barrier regions as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more IC structures with contacts with carbon and metal barrier regions as disclosed herein may take the form of the wafer 1500 (e.g., not singulated) or the form of the die 1502 (e.g., singulated). The die 1502 may include one or more transistors (e.g., one or more of the transistors 1640 of FIG. 12, discussed below) and/or supporting circuitry to route electrical signals to the transistors, as well as any other IC components (e.g., one or more IC structures with contacts with carbon and metal barrier regions). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 14) or other logic that is configured to store information in the memory devices or execute instructions stored in the memory array.

FIG. 12 is a cross-sectional side view of an IC device 1600 that may include one or more IC structures with one or more contacts with carbon and metal barrier regions in accordance with any of the embodiments disclosed herein. The IC device 1600 may be formed on a substrate 1602 (e.g., the wafer 1500 of FIG. 11A) and may be included in a die (e.g., the die 1502 of FIG. 11B). The substrate 1602 may be any substrate as described herein. The substrate 1602 may be part of a singulated die (e.g., the dies 1502 of FIG. 11B) or a wafer (e.g., the wafer 1500 of FIG. 11A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 12 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more contacts with carbon and metal barrier regions at any suitable location in the IC device 1600. For example, the S/D contacts 1624 may include the barrier regions described herein, e.g., in a region of the S/D contact 1624 adjacent to the S/D regions 1620.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 12 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 12). Although a particular number of interconnect layers 1606-1610 is depicted in FIG. 12, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 12. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 12. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

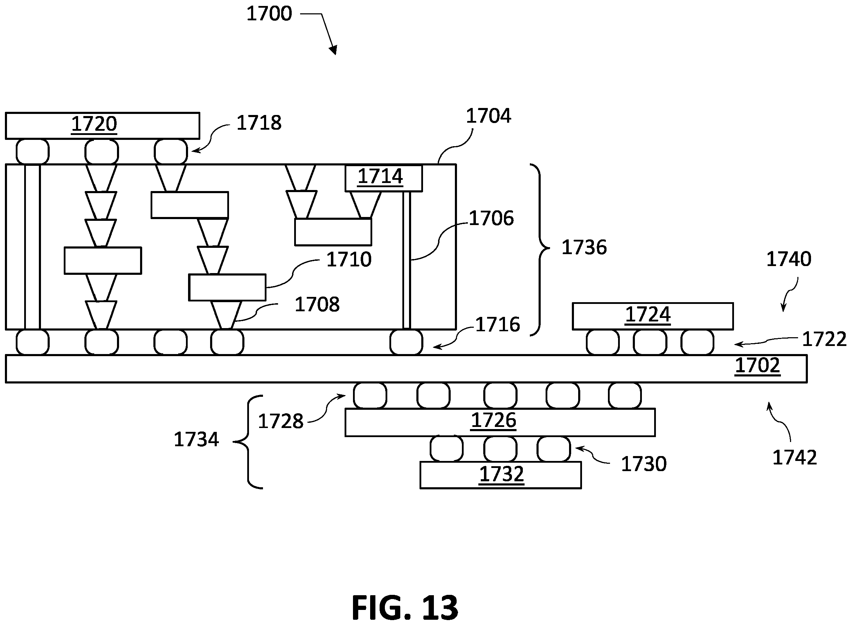

FIG. 13 is a cross-sectional side view of an IC device assembly 1700 that may include components having or being associated with (e.g., being electrically connected by means of) one or more IC structures with contacts with carbon and metal barrier regions in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the contacts with carbon and metal barrier regions, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 13 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 13), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 13, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 11B), an IC device (e.g., the IC device 1600 of FIG. 12), or any other suitable component. In some embodiments, the IC package 1720 may include contacts with carbon and metal barrier regions, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 13, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The interposer 1704 may further include contacts with carbon and metal barrier regions, as described herein. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 13 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 14 is a block diagram of an example computing device 1800 that may include one or more components including one or more IC structures with one or more contacts with carbon and metal barrier regions in accordance with any of the embodiments disclosed herein. For example, any suitable ones of the components of the computing device 1800 may include a die (e.g., the die 1502 of FIG. 11B) having contacts with carbon and metal barrier regions as described herein. Any one or more of the components of the computing device 1800 may include, or be included in, an IC device 1600 (FIG. 12). Any one or more of the components of the computing device 1800 may include, or be included in, an IC device assembly 1700 (FIG. 13).

A number of components are illustrated in FIG. 14 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 14, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an IC device including a transistor having a gate, a channel, and a S/D region; and a S/D contact coupled to the S/D region, the S/D contact including an inner conductive structure and a barrier region including carbon and a metal, the barrier region coupled between the S/D region and the inner conductive structure.

Example 2 provides the IC device of example 1, where the barrier region includes a first layer including carbon and a second layer including the metal.

Example 3 provides the IC device of example 2, where the metal is niobium.

Example 4 provides the IC device of example 2, where the metal is tantalum.

Example 5 provides the IC device of example 2, where the metal is aluminum.

Example 6 provides the IC device of any of examples 2-5, where the first layer has a thickness between 0.1 and 2 nanometers.

Example 7 provides the IC device any of examples 2-6, where the second layer has a thickness between 0.1 and 2 nanometers.

Example 8 provides the IC device of any of examples 2-7, where the barrier region includes a third layer between the first layer and the second layer, the third layer including a metal carbide.

Example 9 provides the IC device of any of examples 2-7, where the barrier region further includes a third layer including carbon, the second layer between the first layer and the third layer.

Example 10 provides the IC device of example 9, where the barrier region further includes a fourth layer including a metal carbide, the fourth layer between the first layer and the third layer; and a fifth layer including a metal carbide, the fifth layer between the third layer and the second layer.

Example 11 provides the IC device of example 2, where the barrier region further includes a third layer between the first layer and the second layer, the third layer including a second metal different from the metal in the second layer.

Example 12 provides the IC device of any of examples 1-11, where the S/D region includes silicon.

Example 13 provides the IC device of any of examples 1-12, further including a second S/D region; and a second S/D contact coupled to the second S/D region, the second S/D contact including an inner conductive structure and a barrier region.

Example 14 provides a contact for an IC device, the contact including an inner conductive structure; a first barrier layer including carbon; and a second barrier layer between the inner conductive structure and the first barrier layer, the second barrier layer including a metal, where the metal is one of niobium, aluminum, and tantalum.

Example 15 provides the contact of example 14, where the first barrier layer is between the second barrier layer and a S/D region, the S/D region including silicon.

Example 16 provides the contact of example 14 or 15, further including a metal carbide between the first barrier layer and the second barrier layer.

Example 17 provides the contact of any of examples 14-16, further including a third barrier layer including carbon, the third barrier layer between the inner conductive structure and the second barrier layer.

Example 18 provides the contact of example 17, further including a metal carbide between the second barrier layer and the third barrier layer.

Example 19 provides the contact of any of examples 14-18, where the inner conductive structure includes titanium.

Example 20 provides a method for fabricating a contact with a barrier region including forming a barrier region over a S/D region of a transistor, the barrier region including carbon and a metal; and forming an inner conductive structure within the barrier region and over the S/D region, the barrier region physically separating the inner conductive structure from the S/D region.

Example 21 provides the method of example 20, where forming the barrier region includes depositing a first barrier layer including carbon and depositing a second barrier layer including the metal.

Example 22 provides the method of example 21, where the first barrier layer and the second barrier layer are each deposited using a conformal deposition method.

Example 23 provides the method of any of examples 20-22, where the metal is one of niobium, tantalum, aluminum, and titanium.

Example 24 provides the method of any of examples 20-23, where the S/D region includes silicon.

Example 25 provides the method of any of examples 20-24, where forming the inner conductive structure includes depositing a titanium layer and depositing a core material over the titanium layer.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a transistor comprising a gate, a channel, and a source/drain (S/D) region; and
a S/D contact coupled to the S/D region, the S/D contact comprising:
an inner conductive structure; and
a barrier region comprising carbon and a metal, the barrier region coupled between the S/D region and the inner conductive structure.

2. The IC device of claim 1, wherein the barrier region comprises a first layer comprising carbon and a second layer comprising the metal.

3. The IC device of claim 2, wherein the metal comprises niobium.

4. The IC device of claim 2, wherein the metal comprises tantalum.

5. The IC device of claim 2, wherein the metal comprises aluminum.

6. The IC device of any one of claims 2-5, wherein the first layer has a thickness between 0.1 and 2 nanometers.

7. The IC device of any one of claims 2-6, wherein the second layer has a thickness between 0.1 and 2 nanometers.

8. The IC device of any one of claims 2-7, wherein the barrier region comprises a third layer between the first layer and the second layer, the third layer comprising a metal carbide.

9. The IC device of any one of claims 2-7, wherein the barrier region further comprises a third layer comprising carbon, the second layer between the first layer and the third layer.

10. The IC device of claim 9, wherein the barrier region further comprises:
a fourth layer comprising a metal carbide, the fourth layer between the first layer and the third layer; and
a fifth layer comprising a metal carbide, the fifth layer between the third layer and the second layer.

11. The IC device of claim 2, wherein the barrier region further comprises a third layer between the first layer and the second layer, the third layer comprising a second metal different from the metal in the second layer.

12. The IC device of any one of claims 1-11, wherein the S/D region comprises silicon.

13. The IC device of any one of claims 1-11, further comprising:
a second S/D region; and
a second S/D contact coupled to the second S/D region, the second S/D contact comprising an inner conductive structure and a barrier region.

14. A method for fabricating a contact with a barrier region comprising:
forming a barrier region over a source or drain (S/D) region of a transistor, the barrier region comprising carbon and a metal; and
forming an inner conductive structure within the barrier region and over the S/D region, the barrier region physically separating the inner conductive structure from the S/D region.

15. The method of claim 14, wherein forming the barrier region comprises depositing a first barrier layer comprising carbon and depositing a second barrier layer comprising the metal.
